# EUROPÄISCHE PATENTSCHRIFT

(11) **EP 2 873 128 B1**
(45) Veröffentlichungstag und Bekanntmachung des Hinweises auf die Patenterteilung: **28.09.2016**
(21) Anmeldenummer: 13755989.4
(22) Anmeldetag: 20.08.2013
(51) Int. Cl.: H02H 7/09, G01R 31/42, H02P 25/04, G01R 29/16, H02J 3/26

(54) **SCHALTGERÄT FÜR EINEN EINPHASENMOTOR UND EINEN DREHSTROMMOTOR**
SWITCHGEAR FOR A SINGLE-PHASE MOTOR AND A THREE-PHASE MOTOR
APPAREIL DE COMMUTATION POUR MOTEUR MONOPHASÉ ET MOTEUR TRIPHASÉ

(30) Priorität: 27.08.2012 DE 102012215166
(43) Veröffentlichungstag der Anmeldung: 20.05.2015
(73) Patentinhaber: Siemens Aktiengesellschaft, 80333 München (DE)
(72) Erfinder: HERTZ, Dirk, 92260 Fichtenhof (DE); SCHÖNENBERG, Marco, 92245 Kümmersbruck (DE); STEUER, Helene, 90455 Nürnberg (DE); ZITZLER, Stefan, 92421 Schwandorf (DE)
(86) Internationale Anmeldenummer: PCT/EP2013/067273
(87) Internationale Veröffentlichungsnummer: WO 2014/033006

(56) Entgegenhaltungen:
- CN-Y- 201 130 850
- JP-A- 2005 227 073
- US-A- 5 896 257
- US-A1- 2012 056 613

## Beschreibung

Die Erfindung betrifft ein Schaltgerät, mittels welchem sowohl ein Einphasenmotor als auch ein Drehstrommotor gesteuert werden kann, sowie ein Verfahren des Schaltgeräts.

Im Bereich der industriellen Automatisierungstechnik werden elektrische Lasten (z.B. ein Elektromotor) zur Energieversorgung an ein Versorgungsnetz angeschlossen. Das Versorgungsnetz ist insbesondere ein Niederspannungsnetz.

In den in Niederspannungsnetzen in Europa üblicherweise verwendeten Spannungen beträgt der Nennwert der Sternspannung 230 Volt. Zur Steuerung einer elektrischen Last wird die Energieversorgung der elektrischen Last über ein Schaltgerät geführt, so dass mittels diesem die Last gesteuert werden kann. Das Schaltgerät ist somit eingangsseitig mit dem Versorgungsnetz verbunden und ausgangsseitig mit der elektrischen Last verbunden. Im Fall von Elektromotoren sind derartige Schaltgeräte üblicherweise Motorstarter.

Ist das Versorgungsnetz ein Dreiphasenwechselstromnetz und der Verbraucher ein Drehstrommotor, so liegt am Verbraucher ein Dreiphasenwechselstrom an. Der Dreiphasenwechselstrom wird über das Schaltgerät, insbesondere über dessen drei Strombahnen, zum Verbraucher geführt, so dass am Schaltgerät ein dreiphasiger Betrieb vorliegt. Bei einem Dreiphasenwechselstrom liegen im ordnungsgemäßen Betrieb drei einzelne Wechselströme bzw. Wechselspannungen gleicher Frequenz vor, welche zueinander eine feste Phasenverschiebung von 120° aufweisen. Ein Wechselstrom ist ein elektrischer Strom, der seine Richtung (Polung) in regelmäßiger Wiederholung ändert und bei dem sich positive und negative Augenblickswerte so ergänzen, dass der Strom im zeitlichen Mittel null ist.

Ist der Verbraucher ein Einphasenmotor so wird eine Phase des Dreiphasenwechselstromnetzes üblicherweise über die einzelnen Strombahnen des Schaltgerätes zum Einphasenmotor geführt. Es liegt am Schaltgerät ein einphasiger Betrieb vor.

Bei elektronischen Schaltgeräten für motorische und nichtmotorische Lasten ist es vorteilhaft, verschiedene Netzfehler, wie Phasenausfall, Phasenüberlast, Phasenunsymmetrie, zu erkennen, um in diesem Fall die Last abzuschalten und dem Bediener den Fehler zu melden. Solche Fehler können das Fehlen einzelner, mehrerer oder aller drei Phasen sein. Auch die Erkennung von Unterbrechungen einzelner oder mehrerer Motorleiter wird mit eingeschlossen.

Zur Ermittlung derartiger Netzfehler, Unsymmetrien und Überlastfälle werden üblicherweise vom zwischengeschalteten Schaltgerät Spannungs- und Stromwerte der einzelnen Phasen erfasst und ausgewertet.

Ein solches Schaltgerät ist aus der US 2012/056613 bekannt.

Es ist Aufgabe der vorliegenden Erfindung ein kostengünstiges Schaltgerät für einen Einphasenmotor und einen Drehstrommotor bereitzustellen, welches im dreiphasigen Betrieb den Ausfall jeder einzelnen Phase erkennen kann sowie im einphasigen Betrieb einen Phasenausfall erkennen kann. Vorzugsweise ermöglicht das Schaltgerät ferner sowohl für den dreiphasigen Betrieb als auch für den einphasigen Betrieb eine Phasenüberlasterkennung bezüglich der angeschlossenen Phasen. Das Schaltgerät erkennt vorzugsweise ferner eine Phasenunsymmetrie und/oder im dreiphasigen Betrieb den Ausfall von zwei beliebigen Phasen und/oder den Ausfall von allen drei Phasen.

Diese Aufgabe wird gelöst durch eine Vorrichtung gemäß Anspruch 1, d.h. durch ein Schaltgerät für einen Einphasenmotor und einen Drehstrommotor, wobei das Schaltgerät eine Verarbeitungseinheit und eine erste, zweite und dritte Strombahn umfasst, wobei die erste und dritte Strombahn jeweils einen Stromwandler umfassen, wobei die Verarbeitungseinheit mittels der Stromwandler den Strom I₁ der ersten Strombahn und den Strom I₃ der dritten Strombahn erfassen kann, wobei die Verarbeitungseinheit derart ausgebildet ist, dass sie die Ströme I₁, I₃ der ersten und dritten Strombahn erfasst und über die Phasenverschiebung zwischen den erfassten Strömen I₁, I₃ der ersten und dritten Strombahn die vorliegende Betriebsart des Schaltgerätes feststellt, und ein Verfahren gemäß Anspruch 8, d.h. durch ein Verfahren eines Schaltgeräts für einen Einphasenmotor und einen Drehstrommotor, wobei das Schaltgerät eine Verarbeitungseinheit und eine erste, zweite und dritte Strombahn umfasst, wobei die erste und dritte Strombahn jeweils einen Stromwandler umfassen, wobei die Verarbeitungseinheit mittels der Stromwandler den Strom I₁ der ersten Strombahn und den Strom I₃ der dritten Strombahn erfassen kann, wobei die Verarbeitungseinheit zum Feststellen einer vorliegenden Betriebsart des Schaltgerätes folgende Schritte durchführt:
- Erfassen der Ströme I₁, I₃ der ersten und dritten Strombahn,
- Ermitteln von die Phasenverschiebung zwischen den erfassten Strömen I₁, I₃ der ersten und dritten Strombahn charakterisierenden Werte anhand der erfassten Ströme I₁, I₃ der ersten und dritten Strombahn,
- Feststellen der vorliegenden Betriebsart des Schaltgerätes durch eine Auswertung der ermittelten die Phasenverschiebung zwischen den erfassten Strömen I₁, I₃ der ersten und dritten Strombahn charakterisierenden Werte.

Vorteilhafte Weiterbildungen der Erfindung sind in den abhängigen Ansprüchen 2 bis 7 sowie 9 bis 15 angegeben.

Über das Schaltgerät kann entweder die Energieversorgung für einen Einphasenmotor geführt werden, so dass als Betriebsart des Schaltgerätes ein Einphasenbetrieb vorliegt. Hierbei wird z.B. die erste, zweite und dritte Strombahn für die Energieversorgung des Einphasenmotors in Serie geschaltet. Alternativ hierzu kann über das Schaltgerät die Energieversorgung für einen Drehstrommotor geführt werden, so dass als Betriebsart des Schaltgerätes ein Dreiphasenbetrieb vorliegt.

Hierbei wird die erste, zweite und dritte Strombahn jeweils mit dem Drehstrommotor und einer Phase des Versorgungsnetzes verbunden.

Das Schaltgerät umfasst vorzugsweise in der zweiten Strombahn keinen Stromwandler. Vorzugsweise weist lediglich die erste und dritte Strombahn des Schaltgeräts jeweils einen Stromwandler auf. Vorzugsweise weist die erste und dritte Strombahn des Schaltgeräts jeweils lediglich einen Stromwandler auf.

Mittels des Schaltgeräts kann vorzugsweise die Energieversorgung für den nachgeschalteten Verbraucher gesteuert werden. Hierfür umfasst das Schaltgerät vorzugsweise in mindestens zwei Strombahnen einen Schalter. Erhält das Schaltgerät ein Startsignal zum Starten des nachgeschalteten Verbrauchers, z.B. von einer übergeordneten Steuerung (z.B. eine speicherprogrammierbare Steuerung), so werden die Schalter derart angesteuert, dass die Energieversorgung des nachgeschalteten Verbrauchers über das Schaltgerät erfolgt. In einem darauf folgenden Schritt erfolgt vorzugsweise seitens des Schaltgerätes automatisch die Feststellung der vorliegenden Betriebsart.

Zum Feststellen der vorliegenden Betriebsart wird zunächst mittels der Stromwandler innerhalb eines Zeitintervalls der Strom I₁, I₃ der ersten und dritten Strombahn erfasst.

Daraufhin ermittelt die Verarbeitungseinheit anhand der erfassten Ströme I₁, I₃ der ersten und dritten Strombahn Werte, welche die Phasenverschiebung zwischen den erfassten Strömen I₁, I₃ der ersten und dritten Strombahn charakterisieren.

Diese ermittelten charakterisierenden Werte werden daraufhin seitens der Verarbeitungseinheit ausgewertet, so dass anhand dieser Auswertung die vorliegende Betriebsart des Schaltgerätes (Einphasenbetrieb oder Dreiphasenbetrieb) festgestellt wird.

Die Ermittlung der Betriebsart durch die Verarbeitungseinheit erfolgt somit mittels einer Auswertung der die Phasenverschiebung zwischen den erfassten Strömen I₁, I₃ der ersten und dritten Strombahn charakterisierenden Werte. Mittels dieser Werte kann durch die Verarbeitungseinheit überprüft werden, ob die abgeleitete Phasenverschiebung zwischen den erfassten Strömen I₁, I₃ der ersten und dritten Strombahn (anhand der die Phasenverschiebung charakterisierende Werte) näher an der Phasenverschiebung des Dreiphasenbetriebs oder des Einphasenbetriebs liegt. Bei einem Dreiphasenbetrieb liegt eine Phasenverschiebung von ca. 120° vor. Bei einem Einphasenbetrieb liegt eine Phasenverschiebung von ca. 0° oder 180° vor.

Bei der Auswertung der ermittelten die Phasenverschiebung charakterisierenden Werte werden diese Werte vorzugsweise mit einem Referenzwert verglichen, so dass ein Rückschluss auf die vorliegende Phasenverschiebung zwischen den erfassten Strömen gewonnen wird, so dass eine Zuordnung zum Dreiphasen- bzw. Einphasenbetrieb erfolgen kann. Mittels des Referenzwerts wird vorzugsweise bezüglich der die Phasenverschiebung charakterisierenden Werte eine Phasenverschiebung von 60° bis 150° als Dreiphasenbetrieb definiert und eine Phasenverschiebung von 0° bis 60° und 150° bis 180° als Einphasenbetrieb definiert. Der Referenzwert kann fest in der Verarbeitungseinheit hinterlegt sein. Es ist jedoch ebenso denkbar, dass der Referenzwert anhand der erfassten Ströme der ersten und dritten Strombahn gebildet wird. Ebenso ist denkbar, dass der Referenzwert mehrerer Schwellwerte definiert, so dass eine Zuordnung zur jeweiligen Betriebsart des Schaltgerätes erfolgen kann.

Die Ermittlung der Phasenverschiebung kann auf unterschiedliche Weise erfolgen. Die Phasenverschiebung kann beispielsweise durch eine Auswertung der Nulldurchgänge und/oder Maxima des vorliegenden Stroms der ersten und dritten Strombahn erfolgen. Hierbei würden die anhand des Erfassten Stroms I₁, I₃ der ersten und dritten Strombahn ermittelten Nulldurchgänge und/oder Maxima die charakterisierenden Werte bilden. Anhand einer Auswertung dieser Werte, insbesondere anhand einer Auswertung des zeitlichen Versatzes der Nulldurchgänge und/oder Maxima des Stroms der beiden Strombahnen zueinander, kann die Phasenverschiebung und somit der Betriebszustand des Schaltgerätes festgestellt werden.

Das Schaltgerät kann somit bei Vorliegen einer aktiven Energieversorgung über das Schaltgerät automatisch und selbstständig feststellen, ob ein Einphasenbetrieb oder ein Dreiphasenbetrieb vorliegt. Mittels dieser Information kann eine spezifische Analyse bezüglich eines Phasenausfalls, einer Phasenüberlast und/oder einer Phasenunsymmetrie der angeschlossenen Phase/-n erfolgen.

Wird der dreiphasige Betrieb erkannt, so wird vorzugsweise der Strom I₁, I₂, I₃ der ersten, zweiten und dritten Strombahn bezüglich der Ermittlung eines Phasenausfalls, einer Phasenüberlast und/oder einer Phasenunsymmetrie ausgewertet. Der Strom der zweiten Strombahn wird hierbei anhand des erfassten Stroms der ersten und dritten Strombahn berechnet.

Wird der Einphasenbetrieb erkannt, so wird lediglich der Strom I₁, I₃ der ersten und/oder dritten Strombahn bezüglich der Ermittlung eines Phasenausfalls und/oder einer Phasenüberlast ausgewertet.

Würde im Einphasenbetrieb der berechnete Strom der zweiten Strombahn bezüglich der Ermittlung des Phasenausfalls und/oder der Phasenüberlast ausgewertet werden, so würde dies zu einer fehlerhaften Analyse führen. Durch eine zuvor durchgeführte Bestimmung der Betriebsart am Schaltgerät kann eine derartig fehlerhafte Analyse vermieden werden.

In einer vorteilhaften Ausführungsform der Erfindung, ist die Verarbeitungseinheit derart ausgebildet, dass sie zum Feststellen der vorliegenden Betriebsart des Schaltgerätes innerhalb eines Zeitintervalls mehrmalig gleichzeitig den Strom I₁, I₃ der ersten und dritten Strombahn erfasst und hierbei die erste Anzahl der positiv erfassten Ströme I₁, I₃ der ersten oder dritten Strombahn sowie die zweite Anzahl der gleichzeitig positiv erfassten Ströme I₁, I₃ der ersten und dritten Strombahn ermittelt und anschließend überprüft, ob die zweite Anzahl größer ist als mindestens ca. 66% der ersten Anzahl.

Unter den Begriff "gleichzeitiges" Erfassen des Stroms I₁, I₃ in der ersten und dritten Strombahn wird ein nahezu zeitgleiches Erfassen der Ströme I₁, I₃ in den beiden Strombahnen gesehen.

Vorzugsweise überprüft die Verarbeitungseinheit ferner ob die erste Anzahl größer ist als mindestens eins, insbesondere größer als ca. zehn. Wurde ein Startsignal seitens des Schaltgeräts umgesetzt, so dass die Energieversorgung zum nachgeschalteten Verbraucher vorliegen müsste, und die Überprüfung ergibt, dass innerhalb des betrachteten Zeitintervalls die erste Anzahl nicht größer als mindestens eins ist, so erfolgt keine Energieversorgung über das Schaltgerät. Es liegt ein Fehler, insbesondere ein Phasenausfall, vor, welcher vorzugsweise als Fehlersignal durch das Schaltgerät ausgegeben wird, z.B. an die übergeordnete Steuerung. Ergibt die Überprüfung durch die Verarbeitungseinheit, dass innerhalb des betrachteten Zeitintervalls die erste Anzahl größer als mindestens eins ist, so kann durch die Verarbeitungseinheit ferner die Ermittlung der vorliegenden Betriebsart erfolgen.

Ergibt die Auswertung durch die Verarbeitungseinheit, dass innerhalb des betrachteten Zeitintervalls die zweite Anzahl größer als mindestens ca. 66%, insbesondere ca. 66%, der ersten Anzahl ist, so liegt ein Einphasenbetrieb vor, d.h. die Energieversorgung eines Einphasenmotors bzw. lediglich einer einphasigen Last erfolgt über das Schaltgerät. Die Verarbeitungseinheit und somit das Schaltgerät erkennt somit selbstständig, dass ein Einphasenbetrieb vorliegt.

Ergibt die Auswertung, dass innerhalb des betrachteten Zeitintervalls die zweite Anzahl nicht größer als mindestens ca. 66%, insbesondere ca. 66%, der ersten Anzahl ist, so liegt ein dreiphasiger Betrieb vor, d.h. die Energieversorgung eines Drehstrommotors bzw. dreiphasigen Last erfolgt über das Schaltgerät. Die Verarbeitungseinheit und somit das Schaltgerät erkennt somit selbstständig, dass ein Dreiphasenbetrieb vorliegt.

Vorzugsweise ist das Zeitintervall mindestens eine Versorgungsnetzstromperiode, insbesondere eine Versorgungsnetzstromperiode. Das Zeitintervall zum wiederholten gleichzeitigen Ermitteln der Ströme I₁, I₃ ist insbesondere fest im Schaltgerät hinterlegt. Innerhalb des Zeitintervalls werden vorzugsweise mindestens viermal die Ströme I₁, I₃ gleichzeitig erfasst. Das Erfassen der Ströme erfolgt vorzugsweise in regelmäßigen Abständen. Vorzugsweise werden innerhalb des Zeitintervalls alle ca. 500µs die Ströme I₁, I₃ gleichzeitig erfasst.

Durch das Zählen der gleichzeitig positiv erfassten Ströme I₁, I₃ der ersten und dritten Strombahn wird ein Rückschluss bezüglich der Phasenverschiebung zwischen dem Strom I₁, I₃ der ersten und dritten Strombahn gewonnen.

Bei dem Zählen der gleichzeitig positiv erfassten Ströme I₁, I₃ der ersten und dritten Strombahn und dem Zählen der positiv erfassten Ströme I₁, I₃ der ersten oder dritten Strombahn werden insbesondere jeweils dieselben Stromerfassungen innerhalb des Zeitintervalls betrachtet.

Die gleichzeitig positiv erfassten Ströme I₁, I₃ der ersten und dritten Strombahn sowie die positiv erfassten Ströme I₁, I₃ der ersten oder dritten Strombahn bildet somit die die Phasenverschiebung zwischen den erfassten Strömen I₁, I₃ der ersten und dritten Strombahn charakterisierenden Werte.

Durch einen Vergleich der zweiten Anzahl mit der ersten Anzahl, mittels welcher ein Referenzwert bezüglich der Phasenverschiebung gebildet wird, kann ein Rückschluss auf die vorliegende Phasenverschiebung und somit ein Rückschluss auf die vorliegende Betriebsart gewonnen werden.

Es ist ebenso denkbar, dass die Verarbeitungseinheit zum Feststellen der vorliegenden Betriebsart des Schaltgerätes innerhalb des Zeitintervalls mehrmalig gleichzeitig den Strom I₁, I₃ der ersten und dritten Strombahn erfasst und hierbei die erste Anzahl der negativ erfassten Ströme I₁, I₃ der ersten oder dritten Strombahn sowie die zweite Anzahl der gleichzeitig negativ erfassten Ströme I₁, I₃ der ersten und dritten Strombahn ermittelt und anschließend überprüft, ob die zweite Anzahl größer ist als mindestens 66% der ersten Anzahl. Ferner kann durch die Verarbeitungseinheit überprüft werden, ob die erste Anzahl größer ist als mindestens eins.

Ergibt die Auswertung durch die Verarbeitungseinheit, dass innerhalb des betrachteten Zeitintervalls die zweite Anzahl größer als mindestens ca. 66%, insbesondere ca. 66%, der ersten Anzahl ist, so liegt ein Einphasenbetrieb vor. Ist die zweite Anzahl nicht größer als mindestens ca. 66%, insbesondere ca. 66%, der ersten Anzahl, so liegt ein dreiphasiger Betrieb vor. Die Verarbeitungseinheit und somit das Schaltgerät erkennt somit selbstständig den vorliegenden Betriebszustand.

Mittels einer Auswertung der negativ erfassten Ströme einer Strombahn mit den gleichzeitig positiv erfassten Strömen, oder umgekehrt, kann ebenso ein Rückschluss auf die vorliegende Phasenverschiebung zwischen den erfassten Strömen I₁, I₃ der ersten und dritten Strombahn erfolgen, so dass die vorliegende Betriebsart festgestellt werden kann.

In einer weiteren vorteilhaften Ausführungsform der Erfindung, ist die Verarbeitungseinheit derart ausgebildet, dass sie im dreiphasigen Betrieb des Schaltgeräts zur Ermittlung eines Phasenausfalls der Phase, welche über die zweite Strombahn geführt wird, mittels gleichzeitig erfasster Ströme I₁, I₃ der ersten und dritten Strombahn einen den Strom I₂ der zweiten Strombahn charakterisierenden Wert berechnet und ermittelt, ob der berechnete Wert einem charakteristischen Phasenausfallstrom entspricht. Die Überwachung auf den Phasenausfallstrom erfolgt insbesondere nach einer Ermittlung der Betriebsart des Schaltgerätes.

Zunächst werden seitens der Verarbeitungseinheit innerhalb eines Zeitintervalls wiederholt die Ströme I₁, I₃ der ersten und dritten Strombahn gleichzeitig erfasst und hieraus ein den Strom I₂ auf der zweiten Strombahn charakterisierender Wert berechnet. Vorzugsweise wird mittels der Verarbeitungseinheit aus den innerhalb des Zeitintervalls gleichzeitig erfassten Strömen I₁, I₃ der Effektivwert des Stroms I₂ berechnet. Die Verarbeitungseinheit kann nach dem Berechnen des charakterisierenden Wertes ermitteln, ob der berechnete charakterisierende Wert (z.B. der Effektivwert des Stroms I₂) dem charakteristischen Phasenausfallstrom entspricht.

Das Zeitintervall und/oder die Wiederholung des gleichzeitigen Erfassens der Ströme I₁, I₃ erfolgt vorzugsweise analog zur Ermittlung der Betriebsart.

Ergibt die Ermittlung der Verarbeitungseinheit, dass der berechnete Wert dem charakteristischen Phasenausfallstrom entspricht, so liegt ein Phasenausfall bezüglich der über die zweite Strombahn geführten Phase vor. Die Verarbeitungseinheit gibt vorzugsweise ein Warnsignal, insbesondere an die übergeordnete Steuerung, aus und/oder unterbindet die Energieversorgung zu dem nachgeschalteten Verbraucher.

In einer weiteren vorteilhaften Ausführungsform der Erfindung, ist die Verarbeitungseinheit derart ausgebildet, dass sie im dreiphasigen Betrieb des Schaltgeräts zur Ermittlung eines Phasenausfalls der Phase, welche über die erste Strombahn geführt wird, ermittelt, ob erfasste Ströme I₁ der ersten Strombahn beständig dem charakteristischen Phasenausfallstrom entsprechen. Die Überwachung auf den Phasenausfallstrom erfolgt vorzugsweise anhand mehrerer innerhalb eines Zeitintervalls (z.B. eine Versorgungsnetzstromperiode) ermittelter Ströme I₁ der ersten Strombahn. Vorzugsweise wird aus den innerhalb des Zeitintervalls erfassten Strömen I₁ der ersten Strombahn ein Effektivwert gebildet und mit dem charakteristischen Phasenausfallstrom verglichen.

Ergibt die Ermittlung der Verarbeitungseinheit, dass die erfassten Ströme I₁ der ersten Strombahn beständig dem charakteristischen Phasenausfallstrom entsprechen, so liegt ein Phasenausfall bezüglich der über die erste Strombahn geführten Phase vor. Die Verarbeitungseinheit gibt vorzugsweise ein Warnsignal, insbesondere an die übergeordnete Steuerung, aus und/oder unterbindet die Energieversorgung zu dem nachgeschalteten Verbraucher.

In einer weiteren vorteilhaften Ausführungsform der Erfindung, ist die Verarbeitungseinheit derart ausgebildet, dass sie im dreiphasigen Betrieb des Schaltgeräts zur Ermittlung eines Phasenausfalls der Phase, welche über die dritte Strombahn geführt wird, ermittelt, ob erfasste Ströme I₃ der dritten Strombahn beständig dem charakteristischen Phasenausfallstrom entsprechen. Die Überwachung auf den Phasenausfallstrom erfolgt vorzugsweise anhand mehrerer innerhalb eines Zeitintervalls (z.B. eine Versorgungsnetzstromperiode) ermittelter Ströme I₃ der dritten Strombahn. Vorzugsweise wird aus den innerhalb des Zeitintervalls erfassten Strömen I₃ der dritten Strombahn ein Effektivwert gebildet und mit dem charakteristischen Phasenausfallstrom verglichen.

Ergibt die Ermittlung der Verarbeitungseinheit, dass die erfassten Ströme I₃ der dritten Strombahn beständig dem charakteristischen Phasenausfallstrom entsprechen, so liegt ein Phasenausfall bezüglich der über die dritte Strombahn geführten Phase vor. Die Verarbeitungseinheit gibt vorzugsweise ein Warnsignal, insbesondere an die übergeordnete Steuerung, aus und/oder unterbindet die Energieversorgung zu dem nachgeschalteten Verbraucher.

Bei der Ermittlung eines Phasenausfalls bezüglich der über die erste und dritte Strombahn geführten Phasen werden vorzugsweise die zur Ermittlung eines Phasenausfalls bezüglich der über die zweite Strombahn geführten Phase innerhalb eines Zeitintervalls gleichzeitig erfassten Ströme I₁, I₃ ausgewertet.

In einer weiteren vorteilhaften Ausführungsform der Erfindung, ist die Verarbeitungseinheit derart ausgebildet, dass sie im einphasigen Betrieb des Schaltgeräts zur Ermittlung eines Phasenausfalls ermittelt, ob erfasste Ströme I₁ der ersten Strombahn und/oder erfasste Ströme I₃ der dritten Strombahn beständig dem charakteristischen Phasenausfallstrom entsprechen.

Die Überwachung auf den Phasenausfallstrom erfolgt vorzugsweise anhand mehrerer innerhalb eines Zeitintervalls (z.B. eine Versorgungsnetzstromperiode) ermittelter Ströme I₁ und/oder I₃. Vorzugsweise wird aus den innerhalb des Zeitintervalls erfassten Ströme I₁, I₃ der ersten und/oder dritten Strombahn ein Effektivwert gebildet und mit dem charakteristischen Phasenausfallstrom verglichen.

Ergibt die Ermittlung der Verarbeitungseinheit, dass die erfassten Ströme I₁ der ersten Strombahn und/oder erfassten Ströme I₃ der dritten Strombahn beständig dem charakteristischen Phasenausfallstrom entsprechen, so liegt ein Phasenausfall vor. Die Verarbeitungseinheit gibt vorzugsweise ein Warnsignal, insbesondere an die übergeordnete Steuerung, aus und/oder unterbindet die Energieversorgung zu dem nachgeschalteten Verbraucher.

In einer vorteilhaften Ausführungsform der Erfindung, liegt der charakteristische Phasenausfallstrom vor, wenn ein in der Verarbeitungseinheit hinterlegter Phasenausfallschwellwert unterschritten wird. Der hinterlegte Phasenausfallschwellwert ist insbesondere abhängig vom vorliegenden Motornennstrom am Schaltgerät. Der Phasenausfallschwellwert ist insbesondere ein Stromwert, welcher kleiner als 30% des am Schaltgerät eingestellten Motornennstroms ist. Vorzugsweise ist der Phasenausfallschwellwert ca. 25% des am Schaltgerät eingestellten Motornennstroms.

Wird der Phasenausfallschwellwert beständig vom ermittelten Strom I₁ der ersten Strombahn oder vom ermittelten Strom I₃ der dritten Strombahn unterschritten oder vom berechneten den Strom der zweiten Strombahn charakterisierenden Wert unterschritten, so liegt ein Phasenausfall bezüglich der über die entsprechenden Strombahn geführten Phase vor.

Die Verarbeitungseinheit ist insbesondere in Mikrocontroller.

Am Schaltgerät kann werksseitig ein fest vorgegebener Motornennstrom für einen anzuschließenden Motor eingestellt sein. Ebenso ist es denkbar, dass am Schaltgerät mittels eines Eingabemittels des Schaltgerätes kundenseitig der Motornennstrom einstellbar ist. Folglich würde der Phasenausfallschwellwert anhand des kundenseitig eingestellten Motornennstroms gebildet werden.

Es ist ebenso denkbar, dass der Phasenausfallschwellwert unabhängig vom Motornennstrom des Schaltgerätes ein fest in der Verarbeitungseinheit hinterlegter Stromwert ist.

In einer weiteren vorteilhaften Ausführungsform der Erfindung, weist das Schaltgerät mindestens zwei Schalter auf, welche in unterschiedlichen Strombahnen des Schaltgerätes verbaut sind. Ein Schalter ist vorzugsweise in der ersten Strombahn und ein anderer Schalter ist vorzugsweise in der dritten Strombahn integriert, so dass durch sie die Energieversorgung über deren Strombahn zum nachgeschalteten Verbraucher unterbunden werden kann. Die Schalter sind vorzugsweise elektromagnetische Relais.

In einer weiteren vorteilhaften Ausführungsform der Erfindung, ist die Verarbeitungseinheit derart ausgebildet, dass durch sie eine Ermittlung einer Phasenüberlast bezüglich der über das Schaltgerät geführten Phase/-n des Versorgungsnetzes erfolgen kann.

Zunächst wird durch die Verarbeitungseinheit der vorliegende Betriebszustand des Schaltgeräts ermittelt.

Liegt ein dreiphasiger Betrieb des Schaltgeräts vor, so wird durch die Verarbeitungseinheit innerhalb eines Zeitintervalls (z.B. eine Versorgungsnetzstromperiode) mehrfach der Strom I₁, I₃ der ersten und dritten Strombahn ermittelt. Anschließend wird durch die Verarbeitungseinheit verglichen, ob innerhalb des Zeitintervalls die ermittelten Ströme I₁ der ersten Strombahn (z.B. der Stromeffektivwert) oder die ermittelten Ströme I₃ der dritten Strombahn (z.B. der Stromeffektivwert) beständig über einem Phasenüberlastschwellwert liegen. Ferner wird durch die Verarbeitungseinheit mittels der gleichzeitig erfassten Ströme I₁, I₃ der ersten und dritten Strombahn ein den Strom I₂ auf der zweiten Strombahn charakterisierenden Wert durch die Verarbeitungseinheit berechnet (z.B. der Stromeffektivwert der zweiten Strombahn) und anschließend mit dem Phasenüberlastschwellwert verglichen.

Liegt ein einphasiger Betrieb des Schaltgeräts vor, so wird durch die Verarbeitungseinheit innerhalb eines Zeitintervalls (z.B. eine Versorgungsnetzstromperiode) mehrfach der Strom I₁, I₃ der ersten und/oder dritten Strombahn ermittelt. Anschließend wird durch die Verarbeitungseinheit verglichen, ob innerhalb der Zeitintervalls die ermittelten Ströme I₁ der ersten Strombahn (z.B. der Stromeffektivwert) und/oder die ermittelten Ströme I₃ der dritten Strombahn (z.B. der Stromeffektivwert) für sich betrachtet oder zusammen beständig über dem Phasenüberlastschwellwert liegen.

Der Phasenüberlastschwellwert ist insbesondere ein Stromwert, welcher um mindestens 20% den am Schaltgerät eingestellten Motornennstroms übersteigt. Der Phasenüberlastschwellwert ist vorzugsweise maximal 120% des am Schaltgerät eingestellten Motornennstroms. Der Phasenüberlastschwellwert ist vorzugsweise in der Verarbeitungseinheit hinterlegt.

Liegt ein beständiges Überschreiten des Phasenüberlastschwellwerts vor, so erkennt die Verarbeitungseinheit eine Überlast der Phase der entsprechenden Strombahn und gibt ein Überlastwarnsignal aus. Mittels des Überlastwarnsignals wird insbesondere die Energieversorgung zum nachgeschalteten Verbraucher unterbunden und/oder ein Signal an eine übergeordnete Steuerung ausgegeben.

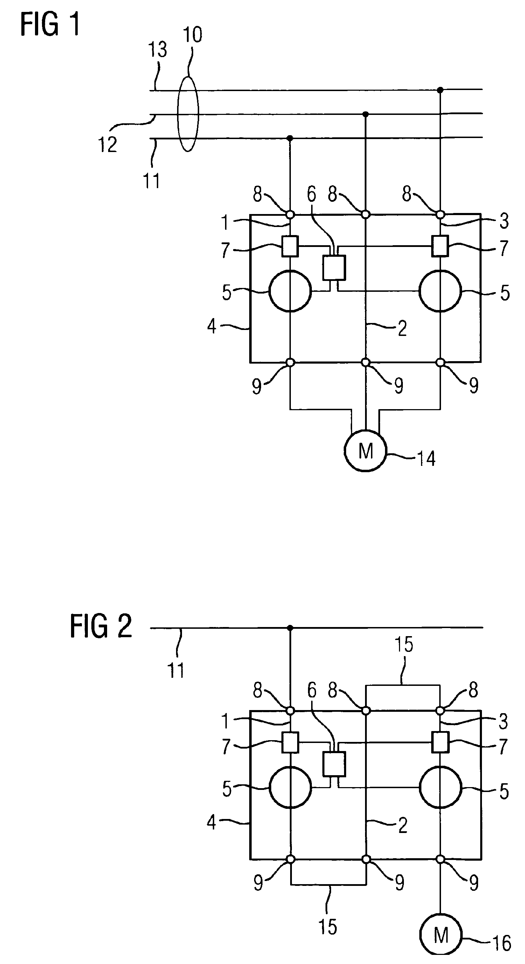

Würde eine Ermittlung des vorliegenden Betriebszustandes nicht erfolgen, so würde bei Vorliegen eines einphasigen Betriebs eine Überwachung der drei Strombahnen auf Überlast gemäß des dreiphasigen Betriebes dazu führen, dass der Strom I₂ der zweiten Strombahn gemäß der in FIG 2 gezeigten Anschlussvariante doppelt so groß wie der Strom I₁ der ersten Strombahn ist. Es würde somit fehlerhaft eine Überlast detektiert werden. Dadurch, dass seitens der Verarbeitungseinheit zunächst die vorliegende Betriebsart ermittelt wird, kann bei der Ermittlung der Phasenüberlast im einphasigen Betrieb des Schaltgerätes gezielt der Strom der zweiten Strombahn unberücksichtigt bleiben.

In einer weiteren vorteilhaften Ausführungsform der Erfindung, ist die Verarbeitungseinheit derart ausgebildet, dass durch sie eine Ermittlung einer Phasenunsymmetrie bezüglich der über das Schaltgerät geführten Phase/-n des Versorgungsnetzes erfolgen kann.

Zunächst wird durch die Verarbeitungseinheit der vorliegende Betriebszustand des Schaltgeräts ermittelt.

Liegt ein dreiphasiger Betrieb des Schaltgeräts vor, so wird durch die Verarbeitungseinheit verglichen, ob einer der erfassten bzw. berechneten Ströme I₁, I₂, I₃ beständig vom Mittelwert der Effektivwerte der erfassten und berechneten Ströme I₁, I₂, I₃ abweicht.

Ein Abweichen liegt insbesondere vor, wenn der Strom über ca. 30 % vom Mittelwert der Effektivwerte der erfassten und/oder berechneten Ströme abweicht.

Liegt ein beständiges Abweichen vom Mittelwert vor, so erkennt die Verarbeitungseinheit eine Phasenunsymmetrie und gibt ein Phasenunsymmetriesignal aus. Mittels des Phasenunsymmetriesignals wird insbesondere die Energieversorgung zum nachgeschalteten Verbraucher unterbunden und/oder ein Signal an eine übergeordnete Steuerung ausgegeben.

Bei der jeweiligen Analyse kann der jeweils ermittelte bzw. berechnete Strom der jeweiligen Strombahn ausgewertet werden. Es kann jedoch ebenso der Effektivwert des Stroms der jeweiligen Strombahn betrachtet werden. Dies gilt insbesondere für den berechneten Strom I₂ der zweiten Strombahn.

Zur jeweiligen Ermittlung werden vorzugsweise die Ströme I₁, I₃ innerhalb eines Zeitintervalls mehrfach gleichzeitig erfasst. Vorzugsweise werden innerhalb des Zeitintervalls die Ströme I₁, I₃ mindestens viermal, insbesondere alle ca. 500µs, gleichzeitig erfasst. Das gleichzeitige Erfassen der Ströme erfolgt vorzugsweise in regelmäßigen Abständen. Das Zeitintervall ist vorzugsweise mindestens eine Periode, insbesondere eine Periode, des Stroms des Versorgungsnetzes.

Zur Phasenausfallerkennung, Phasenunsymmetrie und/oder Überlasterkennung umfasst das Schaltgerät insbesondere lediglich die zwei Stromwandler. Ansonsten findet keine aktive Messung an den Strombahnen bezüglich der Phasenausfallerkennung, Phasenunsymmetrieerkennung und/oder Überlasterkennung statt.

Ein Stromwandler ist ein Messwandler zum potentialfreien Messen großer Wechselströme.

Bei der Analyse ob ein erster Wert beständig von einem zweiten Wert abweicht wird vorzugsweise eine Analyse über ein Zeitintervall durchgeführt, in welchem mehrfach, vorzugsweise mindestens viermal und vorzugsweise in gleichmäßigen Abständen, der Wert erfasst wird. Nach dem Erfassen der ersten Werte innerhalb des Zeitintervalls wird insbesondere der Effektivwert der ersten Werte bezüglich des Zeitintervalls gebildet und mit dem zweiten Wert verglichen.

Das Schaltgerät dient der Steuerung und Überwachung der Energieversorgung eines nachgeschalteten Verbrauchers. Das Schaltgerät ist vorzugsweise ein Motorstarter, insbesondere für Elektromotoren im Niederspannungsbereich.

Anstelle des Effektivwerts des jeweiligen Stroms I₁, I₂, I₃ kann ebenso ein anderer charakteristischer Wert des jeweiligen Stroms I₁, I₂, I₃ gebildet bzw. betrachtet werden.

Im Folgenden werden die Erfindung und Ausgestaltungen der Erfindung anhand der in den Figuren dargestellten Ausführungsbeispiele näher beschrieben und erläutert. Es zeigen:
- FIG 1: eine schematische Darstellung eines Schaltgerätes, über welches die Energieversorgung eines Drehstrommotors geführt ist, und
- FIG 2: eine schematische Darstellung des Schaltgerätes aus FIG 1, über welches die Energieversorgung eines Einphasenmotors geführt ist.

FIG 1 zeigt eine schematische Darstellung eines Schaltgerätes 4, über welches die Energieversorgung eines Drehstrommotors 14 geführt ist, und FIG 2 zeigt eine schematische Darstellung des Schaltgerätes 4 aus FIG 1, über welches die Energieversorgung eines Einphasenmotors 16 geführt ist. Das Schaltgerät 4 aus FIG 1 und FIG 2 ist dasselbe Schaltgerät 4. Das Schaltgerät 4 umfasst, drei eingangseitige Anschlussstellen 8, drei ausgangsseitige Anschlussstellen 9, eine erste, zweite und dritte Strombahn 1,2,3, welche geräteintern zwischen den eingangsseitigen Anschlussstellen 8 und ausgangsseitigen Anschlussstellen 9 angeordnet sind, einen ersten Stromwandler 5 zum Messen des Stroms I₁ der ersten Strombahn 1, einen zweiten Stromwandler 5 zum Messen des Stroms I₃ der dritten Strombahn 3, und eine Verarbeitungseinheit 6. Die erste und dritte Strombahn 1,3 umfasst jeweils einen Schalter 7, mittels welchem eine elektrisch leitende Verbindung zwischen der eingangsseitigen Anschlussstelle 8 und der ausgangsseitigen Anschlussstelle 9 unterbrochen werden kann, so dass die über die jeweilige Strombahn 1,3 erfolgende Energieversorgung zu dem nachgeschalteten Verbraucher 14,16 unterbunden wird. Der Schalter 7 der ersten und dritten Strombahn 1,3 ist jeweils ein elektromagnetisches Relais. Die zweite Strombahn 2 umfasst keinen Stromwandler und ist als durchgehende, nicht gesteuerte Verbindung zwischen der eingangsseitigen und der ausgangsseitigen Anschlussstelle 8,9 ausgebildet. Das Schaltgerät 4 kann mittels seiner Verarbeitungseinheit 6 den vorliegenden Betriebsmodus (Einphasenbetrieb oder Dreiphasenbetrieb) sowie einen Phasenausfall, eine Phasenüberlast und Phasenunsymmetrie bzgl. der über das Schaltgerät 4 geführten Energieversorgung erkennen. Das Schaltgerät 4, insbesondere dessen Verarbeitungseinheit 6, nutzt hierfür lediglich die zwei Stromwandler 5.

Erhält das Schaltgerät 4 den Befehl zum Starten des mit ihm verbundenen nachgeschalteten Verbrauchers 14,16, so steuert die Verarbeitungseinheit 6 die Schalter 7 derart an, dass die Energieversorgung für den nachgeschalteten Verbraucher 14,16 hergestellt wird. Es wird insbesondere eine elektrisch leitende Verbindung zwischen den eingangsseitigen und ausgangsseitigen Anschlussstellen 8,9 bezüglich der ersten und dritten Strombahn 1,3 hergestellt. Das Schaltgerät 4 kann hierauf selbstständig ermitteln, ob es im einphasigen Betrieb oder im dreiphasigen Betrieb betrieben wird. Hierfür führt die Verarbeitungseinheit 6 folgende Schritte durch:

Innerhalb eines Zeitintervalls, hier innerhalb einer Periode des Stroms des Versorgungsnetzes, werden mehrmalig, hier alle 500µs, gleichzeitig die Stromwerte I₁, I₃ der ersten und dritten Strombahn 1,3 erfasst.

Bezüglich der innerhalb des Zeitintervalls gleichzeitig erfassten Stromwerte I₁, I₃ der ersten und dritten Strombahn 1,3 ermittelt die Verarbeitungseinheit 6 die Anzahl (erste Anzahl) der positiven Stromwerte I₁ der ersten Strombahn 1 (ebenso könnte die Anzahl der positiven Stromwerte I₃ der dritten Strombahn 3 ermittelt werden) sowie die Anzahl (zweite Anzahl) der gleichzeitigen positiven Stromwerte I₁, I₃ der ersten und dritten Strombahn 1,3.

Anschließend überprüft die Verarbeitungseinheit 6, ob die erste Anzahl größer als mindestens 1 ist. Hierdurch erkennt die Verarbeitungseinheit 6, ob eine Energieversorgung über das Schaltgerät 4 erfolgt.

Ergibt die Überprüfung, dass innerhalb des betrachteten Zeitintervalls die erste Anzahl nicht größer als mindestens 1 ist, so erfolgt derzeit keine Energieversorgung über das Schaltgerät 4. Es könnte ein Phasenausfall vorliegen. Das Schaltgerät 4 würde eine entsprechende Fehlermeldung an eine übergeordnete Steuerung ausgeben.

Ergibt die Überprüfung, dass innerhalb des betrachteten Zeitintervalls die erste Anzahl größer als mindestens 1 ist, so wird durch die Verarbeitungseinheit ferner überprüft, ob die zweite Anzahl größer als 66% der ersten Anzahl ist.

Ergibt die Überprüfung durch die Verarbeitungseinheit 6, dass innerhalb des betrachteten Zeitintervalls die erste Anzahl größer als mindestens 1 und die zweite Anzahl größer als 66% der ersten Anzahl ist, so stellt Verarbeitungseinheit 6 einen Einphasenbetrieb fest. D.h. die Energieversorgung eines Einphasenmotors 16 erfolgt über das Schaltgerät 4; siehe FIG 2. Wird der Einphasenbetrieb erkannt, so wird lediglich der Strom I₁, I₃ der ersten und/oder dritten Strombahn 1,3 bezüglich der Ermittlung auf einen Phasenausfall und eine Phasenüberlast analysiert. Ferner wird keine Überprüfung der Phasenunsymmetrie durchgeführt.

Ergibt die Überprüfung, dass innerhalb des betrachteten Zeitintervalls die erste Anzahl größer als mindestens 1 ist und die zweite Anzahl kleiner als 66% der ersten Anzahl ist, so stellt die Verarbeitungseinheit 6 einen dreiphasigen Betrieb fest. D.h. die Energieversorgung eines Drehstrommotors 14 erfolgt über das Schaltgerät 4; siehe FIG 1. Wird der dreiphasige Betrieb erkannt, so wird der Strom I₁, I₂, I₃ der ersten, zweiten und dritten Strombahn 1,2,3 bezüglich der Ermittlung auf einen Phasenausfall, eine Phasenüberlast und eine Phasenunsymmetrie analysiert.

Das Schaltgerät 4 kann somit selbstständig erkennen, in welchem Betriebsmodus es betrieben wird.

Da über das Schaltgerät 4 eine Energieversorgung eines nachgeschalteten Verbrauchers 14,16 erfolgt, weist das Schaltgerät 4 einen Motornennstrom bezüglich des anzuschließenden Elektromotors 14,16 auf.

In FIG 1 ist das Schaltgerät 4 innerhalb einer industriellen Anlage mit seinen drei eingangseitigen Anschlussstellen 8 mit den drei Phasen 11,12,13 eines Niederspannungsnetzes 10, hier ein Dreiphasenwechselstromnetz, verbunden. Ein Drehstrommotor 14 ist mit den ausgangsseitigen Anschlussstellen 9 des Schaltgerätes 4 verbunden. Die erste Phase 11 des Niederspannungsnetzes 10 wird über die erste Strombahn 1 zum Drehstrommotor 14 geführt. Mittels des ersten Stromwandlers 5 kann der Strom I₁ der ersten Phase 11 gemessen werden und der Verarbeitungseinheit 6 bereitgestellt werden. Mittels des Schalters 7 der ersten Strombahn 1 kann die elektrisch leitende Verbindung zwischen der eingangsseitigen und ausgangsseitigen Anschlussstelle 8, 9 der ersten Strombahn 1 unterbrochen werden. Die dritte Phase 13 des Niederspannungsnetzes 10 wird über die dritte Strombahn 3 zum Drehstrommotor 14 geführt. Mittels des zweiten Stromwandlers 5 kann der Strom I₃ der dritten Phase 13 gemessen werden und der Verarbeitungseinheit 6 bereitgestellt werden. Mittels des Schalters 7 der dritten Strombahn 3 kann die elektrisch leitende Verbindung zwischen der eingangsseitigen und ausgangsseitigen Anschlussstelle 8, 9 der dritten Strombahn 3 unterbrochen werden.

Die Verarbeitungseinheit 6 kann mittels der Stromwandler 5 gleichzeitig den Strom I₁, I₃ der ersten und dritten Strombahn 1,3 erfassen und hieraus den Strom I₂ der zweiten Strombahn 2 gemäß I₂ = 0 - I₁ - I₃ berechnen. Bei einem wiederholten gleichzeitigen Erfassen des Stroms I₁, I₃ der ersten und dritten Strombahn kann die Verarbeitungseinheit den Strom I₂ der zweiten Strombahn 2 berechnen.

Nachdem das Schaltgerät 4 den dreiphasigen Betrieb festgestellt hat, kann eine Analyse auf einen Phasenausfall, eine Phasenüberlast und eine Phasenunsymmetrie bezüglich der über die drei Strombahnen 1,2,3 geführten drei Phasen 11,12,13 erfolgen.

Zur Ermittlung eines Phasenausfalls der über die zweite Strombahn 2 geführten Phase 12 des Versorgungsnetzes 10 wird zunächst innerhalb eines Zeitintervalls mehrmalig gleichzeitig der Strom I₁, I₃ der ersten und dritten Strombahn 1,3 erfasst.

Mittels der gleichzeitig erfassten Ströme I₁, I₃ der ersten und dritten Strombahn 1,3 wird ein den Strom I₂ auf der zweiten Strombahn 2 charakterisierender Wert berechnet. In diesem Ausführungsbeispiel wird anhand der gleichzeitig erfassten Ströme I₁, I₃ der ersten und dritten Strombahn 1,3 der Strom I₂ der zweiten Strombahn 2 bezüglich des Zeitintervalls berechnet.

Anschließend wird durch die Verarbeitungseinheit 6 ermittelt, ob der berechnete Effektivwert des Stroms I₂ der zweiten Strombahn 2 unterhalb von 20% des am Schaltgerät 4 eingestellten Motornennstroms liegt. Der charakteristische Phasenausfallstrom ist somit ein Strom, welcher geringer als 20% des am Schaltgerät 4 eingestellten Motornennstroms ist.

Liegt der berechnete Strom I₂ der zweiten Strombahn 2 unterhalb von 20% des am Schaltgerät 4 eingestellten Motornennstroms, so liegt ein Phasenausfall bezüglich der zweiten Phase 12 vor. Liegt der berechnete Strom I₂ der zweiten Strombahn 2 oberhalb von 20% des am Schaltgerät 4 eingestellten Motornennstroms, so liegt kein Phasenausfall bezüglich der zweiten Phase 12 vor.

Bei einem Phasenausfall der zweiten Phase 12 liegt eine Phasenverschiebung zwischen der ersten und dritten Phase 11,13 von 180° vor. Da I₁ um 180° Phasenverschoben zu I₃ ist, gilt: I₃ = (-I₁). Folglich ergibt I₂ = 0- I₁ - (-I₁) = 0. Der Wert von I₂ liegt somit unterhalb von 20% des eingestellten Motornennstroms. Bei keinem Phasenausfall ist der Strom I₁ der ersten Strombahn 1 120° phasenversetzt zu dem Strom I₃ der dritten Strombahn 3. Folglich liegt der Wert von I₂ oberhalb von 20% des eingestellten Motornennstroms.

Zur Ermittlung eines Phasenausfalls der über die erste Strombahn 1 geführten Phase 11 des Versorgungsnetzes 10 wird der innerhalb des Zeitintervalls mehrmalig erfasste Strom I₁ der ersten Strombahn 1 ausgewertet. Hierbei wird seitens der Verarbeitungseinheit 6 ein Wert des Stroms I₁ der ersten Strombahn 1 bezüglich des Zeitintervalls gebildet und mit dem charakteristischen Phasenausfallstrom verglichen. Liegt der berechnete Wert des Stroms I₁ der ersten Strombahn 1 unterhalb von 20% des am Schaltgerät 4 eingestellten Motornennstroms, so liegt ein Phasenausfall bezüglich der ersten Phase 11 vor. Liegt der berechnete Wert des Stroms I₁ der ersten Strombahn 1 oberhalb von 20% des am Schaltgerät 4 eingestellten Motornennstroms, so liegt kein Phasenausfall bezüglich der ersten Phase 11 vor.

Zur Ermittlung eines Phasenausfalls der über die dritten Strombahn 3 geführten Phase 13 des Versorgungsnetzes 10 wird der innerhalb des Zeitintervalls mehrmalige erfasste Strom I₃ der dritten Strombahn 3 ausgewertet. Hierbei wird seitens der Verarbeitungseinheit 6 ein Wert des Stroms I₃ der dritten Strombahn 3 bezüglich des Zeitintervalls gebildet und mit dem charakteristischen Phasenausfallstrom verglichen. Liegt der berechnete Wert des Stroms I₃ der dritten Strombahn 3 unterhalb von 20% des am Schaltgerät 4 eingestellten Motornennstroms, so liegt ein Phasenausfall bezüglich der dritten Phase 13 vor. Liegt der berechnete Wert des Stroms I₃ der dritten Strombahn 3 oberhalb von 20% des am Schaltgerät 4 eingestellten Motornennstroms, so liegt kein Phasenausfall bezüglich der dritten Phase 13 vor.

Zur Ermittlung einer Phasenüberlast im dreiphasigen Betrieb des Schaltgeräts 4 wird durch die Verarbeitungseinheit 6 überprüft, ob der Wert des Stroms I₁ der ersten Strombahn 1, der Wert des Stroms I₃ der dritten Strombahn 3 oder der aus den gleichzeitig erfassten Strömen I₁, I₃ der ersten und dritten Strombahn 1,3 berechnete Wert des Stroms I₂ der zweiten Strombahn 2 über einem Phasenüberlastschwellwert liegt. Der Phasenüberlastschwellwert liegt bei 120% des eingestellten Motornennstroms. Liegt einer der Werte der Ströme I₁, I₂, I₃ oberhalb von 120% des eingestellten Motornennstroms, so liegt eine Phasenüberlast an der entsprechenden Phase vor.

Zur Ermittlung einer Phasenunsymmetrie im dreiphasigen Betrieb des Schaltgeräts 4 wird durch die Verarbeitungseinheit 6 überprüft, ob die einzelnen Werte der Ströme I₁, I₂, I₃ vom Mittelwert der Effektivwerte der erfassten und berechneten Ströme I₁, I₂, I₃ bezüglich des betrachteten Zeitintervalls abweichen. Ein Abweichen liegt vor, wenn der betrachtete Strom über ca. 30 % vom Mittelwert der erfassten und berechneten Ströme I₁, I₂, I₃ abweicht.

Wie der FIG 2 zu entnehmen ist, kann das Schaltgerät 4 ebenso zur Steuerung und Überwachung der Energieversorgung eines nachgeschalteten Einphasenmotors 16 verwendet werden. Hierfür ist eine Phase 11 des Niederspannungsnetzes mit der eingangsseitigen Anschlussstelle 8 der ersten Strombahn 1 verbunden. Die ausgangsseitige Anschlussstelle 9 der ersten Strombahn 1 ist mit der ausgangsseitigen Anschlussstelle 9 der zweiten Strombahn 2 mittels eines Verbindungssteckers 15 verbunden. Die eingangsseitige Anschlussstelle 8 der zweiten Strombahn 2 ist mit der eingangsseitigen Anschlussstelle 8 der dritten Strombahn 5 mittels eines weiteren Verbindungssteckers 15 verbunden. Die ausgangsseitigen Anschlussstelle 9 der dritten Strombahn 3 ist mit dem Einphasenmotor 16 verbunden.

Nachdem das Schaltgerät 4 den einphasigen Betrieb festgestellt hat, kann eine Analyse auf einen Phasenausfall und eine Phasenüberlast bezüglich der über die drei Strombahnen 1,2,3 geführte Phase 11 erfolgen. Hierbei erfolgt die Ermittlung eines Phasenausfalls und einer Phasenüberlast nahezu analog zur Analyse bei dem dreiphasigen Betrieb. Beim einphasigen Betrieb wird lediglich die Analyse auf Basis des berechneten Stroms I₂ der zweiten Strombahn 2 nicht durchgeführt.

Zur Ermittlung eines Phasenausfalls wird ein innerhalb eines Zeitintervalls mehrmalig erfasster Strom I₁ der ersten Strombahn 1 ausgewertet. Hierbei wird seitens der Verarbeitungseinheit 6 ein Wert des Stroms I₁ der ersten Strombahn 1 während des Zeitintervalls gebildet und mit dem charakteristischen Phasenausfallstrom verglichen. Liegt der berechnete Wert des Stroms I₁ der ersten Strombahn 1 unterhalb von 20% des am Schaltgerät 4 eingestellten Motornennstroms, so liegt ein Phasenausfall bezüglich der ersten Phase 11 vor. Liegt der berechnete Wert des Stroms I₁ der ersten Strombahn 1 oberhalb von 20% des am Schaltgerät 4 eingestellten Motornennstroms, so liegt kein Phasenausfall bezüglich der ersten Phase 11 vor.

Zur Ermittlung eines Phasenausfalls wird ferner ein innerhalb des Zeitintervalls mehrmalig erfasster Strom I₃ der dritten Strombahn 3 ausgewertet. Hierbei wird seitens der Verarbeitungseinheit 6 ein Wert des Stroms I₃ der dritten Strombahn 3 während des Zeitintervalls gebildet und mit dem charakteristischen Phasenausfallstrom verglichen. Liegt der berechnete Wert des Stroms I₃ der dritten Strombahn 3 unterhalb von 20% des am Schaltgerät 4 eingestellten Motornennstroms, so liegt ein Phasenausfall bezüglich der ersten Phase 11 vor. Liegt der berechnete Wert des Stroms I₃ der dritten Strombahn 3 oberhalb von 20% des am Schaltgerät 4 eingestellten Motornennstroms, so liegt kein Phasenausfall bezüglich der ersten Phase 11 vor.

Zur Ermittlung einer Phasenüberlast im einphasigen Betrieb des Schaltgeräts 4 wird durch die Verarbeitungseinheit 6 überprüft, ob der Wert des Stroms I₁ der ersten Strombahn 1 oder der Wert des Stroms I₃ der dritten Strombahn 3 über dem Phasenüberlastschwellwert liegt.

Bei dem Schaltgerät 4 kann mit nur zwei Stromwandlern 5 und ohne Spannungsmessung in allen Betriebsarten eine fehlende Spannung bzw. fehlende Last erkannt werden. Hierfür ist im Dreiphasenbetrieb die Berechnung des fehlenden Stromes notwendig, um auch in dieser Phase den Phasenausfall erkennen zu können. Dieser berechnet sich aus I₃ = 0 - I₁ - I₃. Für die Phasenausfallerkennung werden die drei ermittelten/berechneten Stromeffektivwerte gegen einen Mindeststrom (hier 20% des eingestellten Motornennstroms) geprüft. Liegt ein oder mehrere Stromwerte dauerhaft unter dieser Schwelle so wird ein Warnsignal an die übergeordnete Steuerung ausgegeben (z.B. Phasenausfall in Phase x).

Bei der Motorschutzerkennung auf eine Unsymmetrie oder Überlast würde bei einem Einphasenbetrieb des Schaltgerätes 4 eine alleinige Analyse des Stroms I₂ der zweiten Strombahn 2 dazu führen, dass das Schaltgerät immer mit einer Fehlermeldung (Unsymmetriewarnsignal bzw. Überlastwarnsignal) auslöst, da der berechnete Strom I₂ der zweiten Strombahn 2 entweder Null oder doppelt so groß wie der Strom I₁, I₃ am ersten und zweiten Stromwandler 5 ist (I₂ = 2*I₁ bzw. I₂ = 2*I₃). Durch die Ermittlung der vorliegenden Betriebsart am Schaltgerät 4, kann eine derartige fehlerhafte Auswertung vermieden werden.

Für die Phasenausfallserkennung im einphasigen Betrieb ist der berechnete Strom I₂ der zweiten Strombahn nicht mehr relevant, so dass dieser nach dem Feststellen, dass ein einphasiger Betrieb am Schaltgerät 4 vorliegt, zur Phasenausfallserkennung nicht betrachtet wird. Sinkt im einphasigen Betrieb der Strom I₁ oder I₃ (sind in diesem Fall identisch) unter den Phasenausfallschwellwert, so löst das Schaltgerät 4 mit einer entsprechenden Fehlermeldung aus. Somit kann auch im einphasigen Betrieb ein Phasenausfall erkannt werden.

Auf diese Weise kann ein kostengünstiges Schaltgerät 4 bereitgestellt werden, welches lediglich unter Verwendung zweier Stromwandler 5 und der zur Auswertung ihrer Signale erforderlichen Verarbeitungseinheit 6 eine umfangreiche Netzfehlererkennung im Drehstrom- und Einphasenbetrieb ermöglichen. Durch die beschriebene Anordnung der Stromwandler 5 im Schaltgerät 4 und die beschriebene Art der Auswertung ihrer Signale werden alle möglichen Ausfälle einzelner, mehrerer oder aller Phasen 11,12,13 beim Betrieb des Schaltgerätes 4 in dreiphasigen und einphasigen Anwendungen erkannt.

## Patentansprüche

1. Schaltgerät (4) für einen Einphasenmotor (16) und einen Drehstrommotor (14), wobei das Schaltgerät (4) eine Verarbeitungseinheit (6) und eine erste, zweite und dritte Strombahn (1,2,3) umfasst, wobei die erste und dritte Strombahn (1,3) jeweils einen Stromwandler (5) umfassen, wobei die Verarbeitungseinheit (6) mittels der Stromwandler (5) den Strom I₁ der ersten Strombahn (1) und den Strom I₃ der dritten Strombahn (3) erfassen kann,
und die Verarbeitungseinheit (6) derart ausgebildet ist, dass sie die Ströme I₁, I₃ der ersten und dritten Strombahn (1,3) erfasst und über die Phasenverschiebung zwischen den erfassten Strömen I₁, I₃ der ersten und dritten Strombahn (1,3) die vorliegende Betriebsart des Schaltgerätes (4) feststellt, **dadurch gekennzeichnet, dass**
die Verarbeitungseinheit (6) derart ausgebildet ist, dass sie zum Feststellen der vorliegenden Betriebsart des Schaltgerätes (4) innerhalb eines Zeitintervalls mehrmalig gleichzeitig die Ströme I₁, I₃ der ersten und dritten Strombahn (1,3) erfasst und hierbei entweder die erste Anzahl der positiv erfassten Ströme I₁, I₃ der ersten oder dritten Strombahn (1,3) sowie die zweite Anzahl der gleichzeitig positiv erfassten Ströme I₁, I₃ der ersten und dritten Strombahn (1,3) ermittelt oder die erste Anzahl der negativ erfassten Ströme I₁, I₃ der ersten oder dritten Strombahn (1,3) sowie die zweite Anzahl der gleichzeitig negativ erfassten Ströme I₁, I₃ der ersten und dritten Strombahn (1,3) ermittelt und anschließend überprüft, ob die zweite Anzahl größer ist als mindestens ca. 66% der ersten Anzahl.

2. Schaltgerät (4) nach Anspruch 1, wobei die Verarbeitungseinheit (6) derart ausgebildet ist, dass sie zum Feststellen der vorliegenden Betriebsart des Schaltgerätes (4) innerhalb eines Zeitintervalls mittels der Stromwandler (5) die Ströme I₁, I₃ der ersten und dritten Strombahn erfasst, anhand der erfassten Ströme I₁, I₃ der ersten und dritten Strombahn Werte, welche die Phasenverschiebung zwischen den erfassten Strömen I₁, I₃ der ersten und dritten Strombahn charakterisieren, ermittelt und die ermittelten charakterisierenden Werte auswertet, so dass anhand dieser Auswertung die vorliegende Betriebsart des Schaltgerätes festgestellt wird.

3. Schaltgerät (4) nach einem der vorhergehenden Ansprüche, wobei lediglich die erste und dritte Strombahn (1,3) jeweils einen Stromwandler (5) umfassen.

4. Schaltgerät (4) nach einem der vorhergehenden Ansprüche, wobei die Verarbeitungseinheit (6) derart ausgebildete ist, dass sie im dreiphasigen Betrieb des Schaltgeräts (4) zur Ermittlung eines Phasenausfalls der Phase (12), welche über die zweite Strombahn (2) geführt wird, mittels gleichzeitig erfasster Ströme I₁, I₃ der ersten und dritten Strombahn (1,3) einen den Strom I₂ der zweiten Strombahn (2) charakterisierenden Wert berechnet und ermittelt, ob der berechnete Wert einem charakteristischen Phasenausfallstrom entspricht.

5. Schaltgerät (4) nach einem der vorhergehenden Ansprüche, wobei die Verarbeitungseinheit (6) derart ausgebildet ist, dass sie zur Ermittlung einer Phasenüberlast innerhalb eines Zeitintervalls
- im dreiphasigen Betrieb des Schaltgeräts (4) vergleicht, ob erfasste Ströme I₁, I₃ der ersten oder dritten Strombahn (1, 3) beständig über einem Phasenüberlastschwellwert liegen und ob ein aus den Strömen I₁, I₃ der ersten und dritten Strombahn berechneter den Strom I₂ auf der zweiten Strombahn (2) charakterisierender Wert beständig über dem Phasenüberlastschwellwert liegt, und/oder
- im einphasigen Betrieb des Schaltgeräts (4) vergleicht, ob erfasste Ströme I₁, I₃ der ersten und/oder dritten Strombahn (1, 3) beständig über dem Phasenüberlastschwellwert liegen.

6. Schaltgerät (4) nach einem der vorhergehenden Ansprüche, wobei die Verarbeitungseinheit (6) derart ausgebildet ist, dass sie zur Ermittlung einer Phasenunsymmetrie
- im dreiphasigen Betrieb vergleicht, ob einer der erfassten und berechneten Ströme I₁, I₂, I₃ der ersten zweiten und dritten Strombahn (1,2,3) beständig vom Mittelwert der Effektivwerte der erfassten und/oder berechneten Ströme I₁, I₂, I₃ abweicht.

7. Verfahren eines Schaltgeräts (4) für einen Einphasenmotor (16) und einen Drehstrommotor (14), wobei das Schaltgerät (4) eine Verarbeitungseinheit (6) und eine erste, zweite und dritte Strombahn (1,2,3) umfasst, wobei die erste und dritte Strombahn (1,3) jeweils einen Stromwandler (5) umfassen, wobei die Verarbeitungseinheit (6) mittels der Stromwandler (5) den Strom I₁ der ersten Strombahn (1) und den Strom I₃ der dritten Strombahn (3) erfassen kann, wobei die Verarbeitungseinheit (6) zum Feststellen einer vorliegenden Betriebsart des Schaltgerätes (4) folgende Schritte durchführt:
- mehrmaliges gleichzeitiges Erfassen der Ströme I₁, I₃ der ersten und dritten Strombahn (1,3) innerhalb eines Zeitintervalls,
- Ermitteln der ersten Anzahl der positiv erfassten Ströme I₁, I₃ der ersten oder dritten Strombahn (1,3) innerhalb des Zeitintervalls und ermitteln der zweiten Anzahl der gleichzeitigen positiv erfassten Ströme I₁, I₃ der ersten und dritten Strombahn (1,3) innerhalb des Zeitintervalls oder
ermitteln der ersten Anzahl der negativ erfassten Ströme I₁, I₃ der ersten oder dritten Strombahn (1,3) innerhalb des Zeitintervalls und ermitteln der zweiten Anzahl der gleichzeitigen negativ erfassten Ströme I₁, I₃ der ersten und dritten Strombahn (1,3) innerhalb des Zeitintervalls,
- Überprüfen ob die ermittelte zweite Anzahl größer als mindestens ca. 66% der ermittelten ersten Anzahl ist.

8. Verfahren nach Anspruch 6 oder 7, wobei im dreiphasigen Betrieb des Schaltgeräts (4) zur Ermittlung eines Phasenausfalls der Phase (12), welche über die zweite Strombahn (2) geführt wird, die Verarbeitungseinheit (6) folgende Schritte durchführt:
- mehrmaliges gleichzeitiges Erfassen des Stroms I₁, I₃ der ersten und dritten Strombahn (1,3),
- Berechnen eines den Strom I₂ auf der zweiten Strombahn (2) charakterisierenden Werts mittels der gleichzeitig erfassten Ströme I₁, 1₃ der ersten und dritten Strombahn (1,3),
- Ermitteln, ob der berechnete Wert einem charakteristischen Phasenausfallstrom entspricht.

9. Verfahren nach Anspruch 7 oder 8, wobei im dreiphasigen Betrieb des Schaltgeräts (4) zur Ermittlung eines Phasenausfalls der Phase (11), welche über die erste Strombahn (1) geführt wird, die Verarbeitungseinheit (6) folgende Schritte durchführt:
- mehrmaliges Erfassen des Stroms I₁ der ersten Strombahn (1),
- Ermitteln, ob die erfassten Ströme I₁ der ersten Strombahn (1) beständig dem charakteristischen Phasenausfallstrom entsprechen.

10. Verfahren nach einem der Ansprüche 7 bis 9, wobei im dreiphasigen Betrieb des Schaltgeräts (4) zur Ermittlung eines Phasenausfalls der Phase (13), welche über die dritte Strombahn (3) geführt wird, die Verarbeitungseinheit (6) folgende Schritte durchführt:
- mehrmaliges Erfassen des Stroms I₃ der dritten Strombahn (3),
- Ermitteln, ob die erfassten Ströme I₃ der dritten Strombahn (3) beständig dem charakteristischen Phasenausfallstrom entsprechen.

11. Verfahren nach einem der Ansprüche 7 bis 10, wobei im einphasigen Betrieb des Schaltgeräts (4) zur Ermittlung eines Phasenausfalls die Verarbeitungseinheit (6) folgende Schritte durchführt:
- mehrmaliges Erfassen des Stroms I₁ der ersten Strombahn (1) und/oder mehrmaliges Erfassen des Stroms I₃ der dritten Strombahn (3),
- Ermitteln, ob die erfassten Ströme I₁ der ersten Strombahn (1) und/oder die erfassten Ströme I₃ der dritten Strombahn (3) beständig dem charakteristischen Phasenausfallstrom entsprechen.

12. Verfahren nach einem der Ansprüche 7 bis 11, wobei die Verarbeitungseinheit (6) zur Ermittlung einer Phasenüberlast im dreiphasigen Betrieb des Schaltgeräts (4) folgende Schritte durchführt:
- mehrmaliges gleichzeitiges Erfassen der Ströme I₁, I₃ der ersten und dritten Strombahn (1,3),
- Berechnen eines den Strom I₂ auf der zweiten Strombahn (2) charakterisierenden Werts mittels der gleichzeitig erfassten Ströme I₁, I₃ der ersten und dritten Strombahn (1,3),
- Ermitteln, ob die erfassten Ströme I₁, I₃ der ersten oder dritten Strombahn (1, 3) beständig über einem Phasenüberlastschwellwert liegen,
- Ermitteln, ob der berechnete den Strom I₂ auf der zweiten Strombahn (2) charakterisierende Wert über dem Phasenüberlastschwellwert liegt,
und im einphasigen Betrieb des Schaltgeräts (4) folgende Schritte durchführt:
- mehrmaliges Erfassen der Ströme I₁, I₃ der ersten und/oder dritten Strombahn (1,3),
- Ermitteln, ob die erfassten Ströme I₁, I₃ der ersten und/oder dritten Strombahn (1, 3) beständig über dem Phasenüberlastschwellwert liegen.

13. Verfahren nach einem der Ansprüche 7 bis 12, wobei die Verarbeitungseinheit (6) zur Ermittlung einer Phasenunsymmetrie:
- im dreiphasigen Betrieb vergleicht, ob einer der Ströme I₁, I₂, I₃ der ersten zweiten und dritten Strombahn (1,2,3) beständig vom Mittelwert der Effektivwerte der erfassten und berechneten Ströme I₁, I₂, I₃ abweicht.

## Claims

1. Switchgear (4) for a single-phase motor (16) and a three-phase motor (14), wherein the switchgear (4) comprises a processing unit (6) and a first, second and third current path (1, 2, 3), wherein the first and third current paths (1, 3) in each case comprise a current transformer (5), wherein the processing unit (6) is able to detect by means of the current transformers (5) the current I₁ of the first current path (1) and the current I₃ of the third current path (3),
the processing unit (6) is configured such that it detects the currents I₁, I₃ of the first and third current paths (1, 3) and ascertains the present operating mode of the switchgear (4) via the phase shift between the detected currents I₁, I₃ of the first and third current paths (1, 3)
**characterised in that**
the processing unit (6) is configured such that it repeatedly detects simultaneously the currents I₁, I₃ of the first and third current paths (1, 3) within a time interval for ascertaining the present operating mode of the switchgear (4) and in this case either determines the first number of positively detected currents I₁, I₃ of the first or third current paths (1, 3) and the second number of simultaneously positively detected currents I₁, I₃ of the first and third current paths (1, 3) or determines the first number of negatively detected currents I₁, I₃ of the first or third current paths (1, 3) and the second number of simultaneously negatively detected currents I₁, I₃ of the first and third current paths (1, 3) and subsequently monitors whether the second number is greater than at least ca. 66% of the first number.

2. Switchgear (4) according to claim 1, wherein the processing unit (6) is configured such that it detects the currents I₁, I₃ of the first and third current paths within a time interval for ascertaining the present operating mode of the switchgear (4) by means of the current transformers (5), determines values which characterize the phase shift between the detected currents I₁, I₃ of the first and third current paths using the detected currents I₁, I₃ of the first and third current paths and evaluates the determined characterizing values, so that using this evaluation the present operating mode of the switchgear is ascertained.

3. Switchgear (4) according to one of the preceding claims, wherein only the first and third current paths (1, 3) in each case comprise a current transformer (5).

4. Switchgear (4) according to one of the preceding claims, wherein the processing unit (6) is configured such that in three-phase operation of the switchgear (4) it calculates a value characterizing the current I₂ of the second current path (2) for determining a phase failure of the phase (12) which is conducted via the second current path (2), by means of simultaneously detected currents I₁, I₃ of the first and third current paths (1, 3), and determines whether the calculated value corresponds to a characteristic phase failure current.

5. Switchgear (4) according to one of the preceding claims, wherein the processing unit (6) is configured such that for determining a phase overload within a time interval
- in three-phase operation of the switchgear (4) it compares whether detected currents I₁, I₃ of the first or third current paths (1, 3) are continuously above a phase overload threshold value and whether a value calculated from the currents I₁, I₃ of the first and third current paths, characterizing the current I₂ on the second current path (2), is continuously above the phase overload threshold value and/or
- in single-phase operation of the switchgear (4) it compares whether detected currents I₁, I₃ of the first and/or third current path (1, 3) are continuously above the phase overload threshold value.

6. Switchgear (4) according to one of the preceding claims, wherein the processing unit (6) is configured such that for determining a phase unbalance
- in three-phase operation it compares whether one of the detected and calculated currents I₁, I₂, I₃ of the first, second and third current paths (1, 2, 3) continuously deviates from the mean value of the effective values of the detected and/or calculated currents I₁, I₂, I₃.

7. Method of a switchgear (4) for a single-phase motor (16) and a three-phase motor (14), wherein the switchgear (4) comprises a processing unit (6) and a first, second and third current path (1, 2, 3), wherein the first and third current paths (1, 3) in each case comprise a current transformer (5), wherein the processing unit (6) is able to detect by means of the current transformers (5) the current I₁ of the first current path (1) and the current I₃ of the third current path (3), wherein for ascertaining a present operating mode of the switchgear (4) the processing unit (6) performs the following steps:
- repeatedly detecting simultaneously the currents I₁, I₃ of the first and third current paths (1, 3) within a time interval,
- determining the first number of positively detected currents I₁, I₃ of the first or third current path (1, 3) within the time interval and determining the second number of simultaneously positively detected currents I₁, I₃ of the first and third current paths (1, 3) within the time interval or
determining the first number of negatively detected currents I₁, I₃ of the first or third current path (1, 3) within the time interval and determining the second number of simultaneously negatively detected currents I₁, I₃ of the first and third current paths (1, 3) within the time interval,
- monitoring whether the determined second number is greater than at least ca. 66% of the determined first number.

8. Method according to claim 6 or 7, wherein in three-phase operation of the switchgear (4) for determining a phase failure of the phase (12) which is conducted via the second current path (2), the processing unit (6) performs the following steps:
- repeatedly detecting simultaneously the current I₁, I₃ of the first and third current paths (1, 3),
- calculating a value characterizing the current I₂ on the second current path (2) by means of the simultaneously detected currents I₁, I₃ of the first and third current paths (1, 3),
- determining whether the calculated value corresponds to a characteristic phase failure current.

9. Method according to claim 7 or 8, wherein in three-phase operation of the switchgear (4) for determining a phase failure of the phase (11) which is conducted via the first current path (1), the processing unit (6) performs the following steps:
- repeatedly detecting the current I₁ of the first current path (1),
- determining whether the detected currents I₁ of the first current path (1) continuously correspond to the characteristic phase failure current.

10. Method according to one of claims 7 to 9, wherein in three-phase operation of the switchgear (4) for determining a phase failure of the phase (13) which is conducted via the third current path (3), the processing unit (6) performs the following steps:
- repeatedly detecting the current I₃ of the third current path (3),
- determining whether the detected currents I₃ of the third current path (3) continuously correspond to the characteristic phase failure current.

11. Method according to one of claims 7 to 10, wherein in single-phase operation of the switchgear (4) for determining a phase failure, the processing unit (6) performs the following steps:
- repeatedly detecting the current I₁ of the first current path (1) and/or repeatedly detecting the current I₃ of the third current path (3),
- determining whether the detected currents I₁ of the first current path (1) and/or the detected currents I₃ of the third current path (3) continuously correspond to the characteristic phase failure current.

12. Method according to one of claims 7 to 11, wherein in three-phase operation of the switchgear (4) for determining a phase overload, the processing unit (6) performs the following steps:
- repeatedly detecting simultaneously the currents I₁, I₃ of the first and third current paths (1, 3),
- calculating a value characterizing the current I₂ on the second current path (2) by means of the simultaneously detected currents I₁, I₃ of the first and third current paths (1, 3),
- determining whether the detected currents I₁, I₃ of the first or third current path (1, 3) are continuously above a phase overload threshold,
- determining whether the calculated value characterizing the current I₂ on the second current path (2) is above the phase overload threshold value,
and in single-phase operation of the switchgear (4) performs the following steps:
- repeatedly detecting the currents I₁, I₃ of the first and/or third current paths (1, 3),
- determining whether the detected currents I₁, I₃ of the first and/or third current path (1, 3) are continuously above the phase overload threshold value.

13. Method according to one of claims 7 to 12, wherein for determining a phase unbalance, the processing unit (6):
- in three-phase operation compares whether one of the currents I₁, I₂, I₃ of the first, second and third current paths (1, 2, 3) continuously deviates from the mean value of the effective values of the detected and calculated currents I₁, I₂, I₃.

## Revendications

1. Appareil (4) de commutation pour un moteur (16) monophasé et un moteur (14) triphasé, dans lequel l'appareil (4) de commutation comprend une unité (6) de traitement et une première, deuxième et troisième voies (1, 2, 3) de courant, la première et troisième voies (1, 3) de courant comprennent respectivement un transformateur (5) de courant, l'unité (6) de traitement pouvant, au moyen du transformateur (5) de courant, détecter le courant I₁ de la première voie (1) de courant et le courant I₃ de la troisième voie (3) de courant,
et l'unité (6) de traitement est constituée de manière à détecter les courants I₁, I₃ de la première et troisième voies (1, 3) de courant et à constater, par le déphasage entre les courants I₁, I₃ détectés de la première et troisième voies (1, 3), le type de fonctionnement présent de l'appareil (4) de commutation,
**caractérisé en ce que**
l'unité (6) de traitement est constituée de manière à détecter, pour la constatation du type de fonctionnement présent de l'appareil (4) de commutation dans un intervalle de temps plusieurs fois en même temps, les courants I₁, I₃ de la première et de la troisième voies (1, 3) de courant et ainsi à déterminer soit le premier nombre des courants I₁, I₃ détectés positivement de la première ou de la troisième voie (1, 3) de courant, ainsi que le deuxième nombre des courants I₁, I₃ détectés positivement en même temps de la première et de la troisième voies (1, 3) de courant, soit le premier nombre des courants I₁, I₃ détectés négativement de la première ou de la troisième voie (1, 3) de courant, ainsi que le deuxième nombre des courants I₁, I₃ détectés négativement en même temps de la première et de la troisième voies (1, 3) de courant, et à contrôler ensuite si le deuxième nombre est plus grand qu'au moins environ 66% du premier nombre.

2. Appareil (4) de commutation suivant la revendication 1, dans lequel l'unité (6) de traitement est constituée de manière à détecter, pour la constatation du type de fonctionnement présent de l'appareil (4) de commutation dans un intervalle de temps au moyen du transformateur (5) de courant, les courants I₁, I₃ de la première et de la troisième voies de courant, à déterminer, à l'aide des courants I₁, I₃ détectés de la première et de la troisième voies de courant, des valeurs, qui caractérisent le déphasage entre les courants I₁, I₃ détectés de la première et de la troisième voies de courant et à exploiter les valeurs caractérisantes déterminées, de manière de constater, à l'aide de cette exploitation, le type de fonctionnement présent de l'appareil de commutation.

3. Appareil (4) de commutation suivant l'une des revendications précédentes, dans lequel seulement la première et la troisième voies (1, 3) de courant comprennent respectivement un transformateur (5) de courant.

4. Appareil (4) de commutation suivant l'une des revendications précédentes, dans lequel l'unité (6) de traitement est constituée de manière à calculer, dans le fonctionnement triphasé de l'appareil (4) de commutation, pour la détermination d'une défaillance de la phase (12), qui passe par la deuxième voie (2) de courant, au moyen des courants I₁, I₃ détectés en même temps de la première et de la troisième voies (1, 3) de courant, une valeur caractérisant le courant I₂ de la deuxième voie (2) de courant et à déterminer si la valeur calculée correspond à un courant caractéristique de défaillance de phase.

5. Appareil (4) de commutation suivant l'une des revendications précédentes, dans lequel l'unité (6) de traitement est constituée de manière à, pour la détermination d'une surcharge de phase dans un intervalle de temps,
- comparer, dans le fonctionnement triphasé de l'appareil (4) de commutation, si des courants I₁, I₃ détectés de la première et de la troisième voies (1, 3) de courant sont constamment au-dessus d'une valeur de seuil de surcharge de phase et si une valeur, calculée à partir des courants I₁, I₃ de la première et de la troisième voies de courant et caractérisant le courant I₂ sur la deuxième voie (2) de courant, est constamment au-dessus de la valeur de seuil de surcharge de phase et/ou
- comparer, dans un fonctionnement monophasé de l'appareil (4) de commutation, si des courants I₁, Iₛ détectés de la première et/ou de la troisième voies (1, 3) de courant se trouvent constamment au-dessus de la valeur de seuil de surcharge de phase.

6. Appareil (4) de commutation suivant l'une des revendications précédentes, dans lequel l'unité (6) de traitement est constituée de manière à, pour la détermination d'une dissymétrie de phase,
- comparer, dans le fonctionnement triphasé, si l'un des courants I₁, I₂, I₃ détectés et calculé de la première, deuxième et troisième voies (1, 2, 3) de courant s'écarte constamment de la valeur moyenne des valeurs efficaces des courants I₁, I₂, I₃ détectés et/ou calculés.

7. Procédé de fonctionnement d'un appareil (4) de commutation d'un moteur (16) monophasé et d'un moteur (14) triphasé, l'appareil (4) de commutation comprenant une unité (6) de traitement et une première, deuxième et troisième voies (1, 2, 3) de courant, la première et troisième voies (1, 3) de courant comprenant respectivement un transformateur (5) de courant, l'unité (6) de traitement pouvant, au moyen du transformateur (5) de courant, détecter le courant I₁ de la première voie (1) de courant et le courant I₃ de la troisième voie (3) de courant, l'unité (6) de traitement effectuant, pour constater un état de fonctionnement présent de l'appareil (4) de commutation, les stades suivants :
- détection plusieurs fois simultanément des courants I₁, I₃ de la première et de la troisième voies (1, 3) de courant dans un intervalle de temps,
- détermination du premier nombre de courants I₁, I₃ détectés positivement de la première ou de la troisième voie (1, 3) de courant dans l'intervalle de temps et détermination du deuxième nombre des courants I₁, I₃ détectés positivement en même temps de la première et de la troisième voies (1, 3) de courant dans l'intervalle de temps ou
- détermination du premier nombre des courants I₁, I₃ détectés négativement de la première ou de la troisième voies (1, 3) de courant dans l'intervalle de temps et détermination du deuxième nombre des courants I₁, I₃ détectés négativement en même temps de la première et de la troisième voies (1, 3) de courant dans l'intervalle de temps,
- contrôle du point de savoir si le deuxième nombre déterminé est plus grand qu'au moins environ 66% du premier nombre déterminé.

8. Procédé suivant la revendication 6, dans lequel, dans le fonctionnement triphasé de l'appareil (4) de commutation, l'unité (6) de traitement effectue, pour déterminer une défaillance de la phase (12), qui passe par la deuxième voie (2) de courant, les stades suivants :
- détection plusieurs fois en même temps des courants I₁, I₃ de la première et de la troisième voies (1, 3) de courant,
- calcul d'une valeur caractérisant le courant I₂ sur la deuxième voie (2) de courant au moyen des courants I₁, I₃ détectés en même temps de la première et de la troisième voies (1, 3) de courant,
- détermination du point de savoir si la valeur calculée correspond à un courant caractéristique de défaillance de la phase.

9. Procédé suivant la revendication 7 ou 8, dans lequel, dans le fonctionnement triphasé de l'appareil (4) de commutation, l'unité (6) de traitement effectue, pour la détermination d'une défaillance de la phase (11), qui passe par la première voie (1) de courant, les stades suivants :
- détection plusieurs fois du courant I₁ de la première voie (1) de courant,
- détermination du point de savoir si le courant I₁ détecté de la première voie (1) de courant correspond constamment au courant caractéristique de défaillance de la phase.

10. Procédé suivant l'une des revendications 7 à 9, dans lequel, dans le fonctionnement triphasé de l'appareil (4) de commutation, l'unité (6) de traitement effectue, pour la détermination d'une défaillance de la phase (13), qui passe par la troisième voie (3) de courant, les stades suivants :
- détection plusieurs fois du courant I₃ de la troisième voie (3) de courant,
- détermination du point de savoir si le courant I₃ détecté de la troisième voie (3) de courant correspond constamment au courant caractéristique de défaillance de la phase.

11. Procédé suivant l'une des revendications 7 à 10, dans lequel, dans le fonctionnement monophasé de l'appareil (4) de commutation, l'unité (6) de traitement effectue, pour déterminer une défaillance de phase, les stades suivants :
- détection plusieurs fois du courant I₁ de la première voie (1) de courant et/ou détection plusieurs fois du courant I₃ de la troisième voie (3) de courant,
- détermination du point de savoir si le courant I₁ détecté de la première voie (1) de courant et/ou le courant I₃ détecté de la troisième voie (3) de courant correspondent constamment au courant caractéristique de défaillance de phase.

12. Procédé suivant l'une des revendications 7 à 11, dans lequel l'unité (6) de traitement effectue, pour la détermination d'une surcharge de phase dans le fonctionnement triphasé de l'appareil (4) de commutation, les stades suivants :
- détection plusieurs fois en même temps des courants I₁, I₃ de la première et de la troisième voies (1, 3) de courant,
- calcul d'une valeur caractérisant le courant I₂ sur la deuxième voie (2) de courant au moyen des courants I₁, I₃ détectés en même temps de la première et de la troisième voies (1, 3) de courant,
- détermination du point de savoir si les courants I₁, I₃ détectés de la première et/ou de la troisième voie (1, 3) de courant sont constamment au-dessus d'une valeur de seuil de surcharge de phase,
- détermination du point de savoir si la valeur calculée caractérisant le courant I₂ sur la deuxième (2) de courant se trouve au-dessus de la valeur de seuil de surcharge de phase,
et, dans le fonctionnement monophasé de l'appareil (4) de commutation, effectue les stades suivants :
- détection plusieurs fois des courants I₁, I₃ de la première et/ou de la troisième voie (1, 3) de courant,
- détermination du point de savoir si les courants I₁, I₃ détectés de la première et/ou de la troisième voie (1, 3) de courant sont constamment au-dessus de la valeur de seuil de surcharge de phase.

13. Procédé suivant l'une des revendications 7 à 12, dans lequel l'unité (6) de traitement, pour la détermination d'une dissymétrie de phase :
- compare, dans le fonctionnement triphasé, si l'un des courants I₁, I₂, I₃ de la première, deuxième et troisième voies (1, 2, 3) de courant s'écarte constamment de la valeur moyenne des valeurs efficaces des courants I₁, I₂, I₃ détectés et calculés.
